# DEMANDE DE BREVET EUROPEEN

(11) **EP 1 978 793 A1**
(43) Date de publication de la demande: **08.10.2008**
(21) Numéro de dépôt: 07300914.4
(22) Date de dépôt: 02.04.2007
(51) Int. Cl.: H05K 3/30, H05K 3/32

(54) **Composant pour circuit imprimé**

(71) Demandeur: Delphi Technologies, Inc., Troy, MI 48007 (US)
(72) Inventeur: Jawdoszyn, Claude, 95110, Sannois (FR)
(74) Mandataire: Laget, Jean-Loup

(57) **Abrégé**

Composant (10) destiné à être monté sur un support (15) de circuit imprimé, comprenant un corps (13) et une patte (25) apte à être insérée dans et à traverser un orifice (14) ménagé dans le support de manière à fixer le corps au support et à relier électriquement le corps au support, caractérisé par le fait que la patte présente une portion d'appui (11) et une portion déformable (12), la portion déformable étant apte, quand la portion d'appui est en appui sur une première face (23) du support, à être déformée de manière à prendre appui sur une deuxième face (24) du support opposée à la première face, afin de fixer le corps au support et de relier électriquement le corps au support, sans soudure.

## Description

La présente invention se rapporte à un composant destiné à être monté sur un support de circuit imprimé, à un dispositif électrique ou électronique comprenant ce composant et le support de circuit imprimé, ainsi qu'à un procédé de montage du composant sur le support de circuit imprimé.

Pour fixer un composant volumineux et lourd sur un support de circuit imprimé, et relier électriquement le composant au circuit imprimé, il est connu de réaliser une soudure au niveau des broches de raccordement électrique du composant, qui passent dans des orifices métallisés ménagés dans le support. La soudure peut être réalisée manuellement ou de manière industrielle au moyen de vagues d'étain en fusion.

L'opération de soudure par vague comporte un certain nombre d'inconvénients qui tiennent au fait qu'il peut y avoir un risque de soulèvement du composant au moment du passage de la vague et qui induit des mauvaises soudures ou des soudures incomplètes, qui se traduiront par un non-fonctionnement éventuel du composant. Ce problème oblige à concevoir des systèmes complexes de maintien du composant pendant l'opération de soudure.

Un autre inconvénient est le risque de casse de la soudure qui peut survenir en cas de chute du dispositif fini, par exemple lors de la manipulation ou du montage sur un véhicule automobile. En effet, la masse du composant génère des efforts très important sur les soudures et/ou les pistes de cuivre. Ce problème conduit également à concevoir, dans l'environnement immédiat du composant, des butées pour s'opposer à cette conséquence physique. Dans le cas d'un dispositif fini monté dans un véhicule automobile, les vibrations dues au roulage et les imperfections de la route peuvent également provoquer des problèmes similaires.

Les cahiers des charges des constructeurs automobiles imposent des tests dits de « drop test », consistant en plusieurs chutes de 1 m de haut sur un sol en béton. Il est difficile de satisfaire à cette contrainte avec une fixation du composant par soudure.

Un autre inconvénient se présente dans le cas où les deux faces du support de circuit imprimé sont équipées de composants, par exemple une face avec des composants traditionnels traversants et l'autre avec des composants de surface de type CMS. Cela oblige à avoir au moins deux types de procédé de montage : Vague pour les composants traversants et four de refusion pour les composants de surface.

Il est également connu de fixer un composant sur un support de circuit imprimé sans soudure. Par exemple, le document DE 39 36 843 A1 décrit un montage par insertion à force des broches dans des orifices métallisés. Ce montage ne convient pas aux composants volumineux et lourds car il n'offre pas une résistance mécanique suffisante. Dans le document US 2002/0113311 A1, le composant présente des contacts en forme de rivet qui sont insérés et déformés dans des orifices borgnes ménagés dans des terminaux de contact du support de circuit imprimé. La résistance mécanique de ce type de fixation est limitée à celle de la fixation des terminaux de contact sur le support de circuit imprimé, et ne convient pas non plus à des composants volumineux et lourds.

L'invention a pour but de proposer un composant qui ne présente pas au moins certains des inconvénients précités de l'art antérieur.

Pour cela, l'invention fournit un composant destiné à être monté sur un support de circuit imprimé, comprenant un corps et une patte apte à être insérée dans et à traverser un orifice ménagé dans le support de manière à fixer le corps au support et à relier électriquement le corps au support, caractérisé par le fait que la patte présente une portion d'appui et une portion déformable, la portion déformable étant apte, quand la portion d'appui est en appui sur une première face du support, à être déformée de manière à prendre appui sur une deuxième face du support opposée à la première face, afin de fixer le corps au support et de relier électriquement le corps au support, sans soudure.

Grâce à ces caractéristiques, aucune soudure n'est nécessaire pour fixer le composant sur le support de circuit imprimé. La patte présente une forme qui accepte une fixation du type rivetage ou sertissage : La déformation de la partie déformable permet de réaliser une fixation mécanique du type rivet ou sertissage. Ce type de fixation présente une très bonne résistance mécanique et convient donc pour les composants volumineux et lourds, par exemple un transformateur, un accumulateur ou un élément mécatronique, dont le poids dépasse généralement 10 g et peut atteindre plusieurs dizaines de grammes. De plus la déformation de la partie déformable permet d'assurer un contact serré entre la patte et une partie métallisée du support de circuit imprimé, assurant ainsi une liaison électrique de qualité.

De préférence, la portion d'appui comprend une paroi plane, et la portion déformable comprend un élément faisant saillie depuis la paroi plane.

Avantageusement, l'élément faisant saillie présente une forme cylindrique ou tronconique creuse.

Selon un mode de réalisation particulier, le composant présentant un poids supérieur à 10g.

De préférence, le corps comprend un transformateur et/ou un accumulateur et/ou un élément mécatronique.

Avantageusement, le composant comprend une pluralité de pattes comprenant chacune une portion d'appui et une portion déformable.

L'invention fournit également un dispositif électrique ou électronique, réalisé avec un composant selon l'invention ci-dessus, et comprenant un support de circuit imprimé dans lequel est ménagé un orifice, la patte du composant étant insérée dans l'orifice du support avec sa portion d'appui en appui sur une première face du support et sa portion déformable qui est déformée de manière à prendre appui sur une deuxième face du support opposée à la première face, afin de fixer le corps au support et de relier électriquement le corps au support, sans soudure.

De préférence, la portion déformée comprend une rivure plus large que les dimensions de l'orifice et repliée vers la deuxième face du support.

L'invention fournit également un procédé de montage d'un dispositif électrique ou électronique selon l'invention ci-dessus, comprenant les étapes consistant à :
- insérer la patte du composant dans l'orifice du support, avec sa portion d'appui en appui sur la première face du support et sa portion déformable qui fait saillie au niveau de la deuxième face du support,
- déformer la portion déformable de manière à ce qu'elle prenne appui sur la deuxième face.

De préférence, l'étape de déformation est réalisée avec un outil comprenant un poinçon et une matrice.

L'invention sera mieux comprise, et d'autres buts, détails, caractéristiques et avantages de celle-ci apparaîtront plus clairement au cours de la description suivante d'un mode de réalisation particulier de l'invention, donné uniquement à titre illustratif et non limitatif, en référence aux dessins annexés. Sur ces dessins :
- la figure 1 est une vue en perspective d'un composant selon un mode de réalisation de l'invention, et d'un support de circuit imprimé, avant montage,
- les figures 2 à 4 sont des vues en coupe d'un détail du composant et du support de la figure 1, au cours de différentes étapes de montage,
- la figure 5 est une vue similaire à la figure 1, après montage,
- la figure 6 est une vue similaire à la figure 5, qui illustre une variante de réalisation.

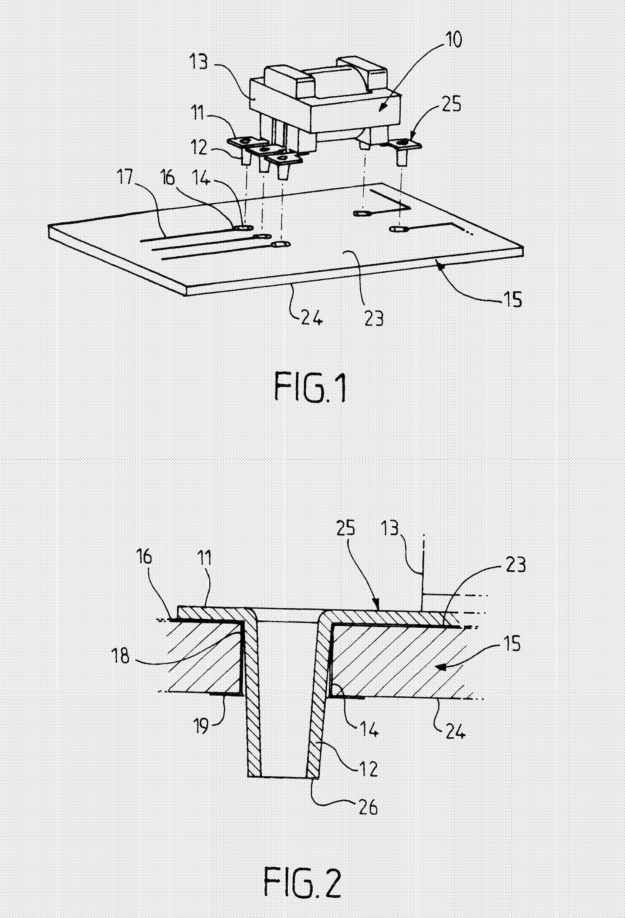

Le composant 10 représenté sur la figure 1 comprend un corps 13 et cinq pattes 25. Dans l'exemple représenté, le corps 13 est un transformateur. Les pattes 25 sont destinées être insérées dans des orifices 14 d'un support 15 de circuit imprimé pour fixer mécaniquement le composant 10 sur le support 15, et relier électriquement le corps 13 à des pistes 17 du support 15.

En référence à la figure 2, on décrit maintenant plus en détail l'un des orifices 14 et l'une des pattes 25.

L'orifice 14 présente une section circulaire et traverse le support 15. Il est entouré par une zone métallique circulaire 16 sur une première face 23 du support 15, et par une zone métallique circulaire 19 sur une deuxième face 24 du support 15. Les zones métalliques circulaires 16 et 19 sont reliées par une couche métallique 18 dans l'orifice 14. La zone métallique circulaire 16 est reliée à une piste 17.

La patte 25 présente une paroi plane 11 qui s'étend parallèlement à la première face 23 du support 15. Un élément en saillie 12 s'étend perpendiculairement à la paroi plane 11, du côté opposé au corps 13. L'élément en saillie 12 présente une forme cylindrique ou tronconique creuse, et des dimensions correspondant à celle de l'orifice 14 : Comme le montre la figure 2, l'élément en saille 12 peut être inséré dans l'orifice 14 de manière que son extrémité 26 dépasse du côté de la deuxième face 24 du support 15, quand la paroi plane 11 est en appui contre la première face 23.

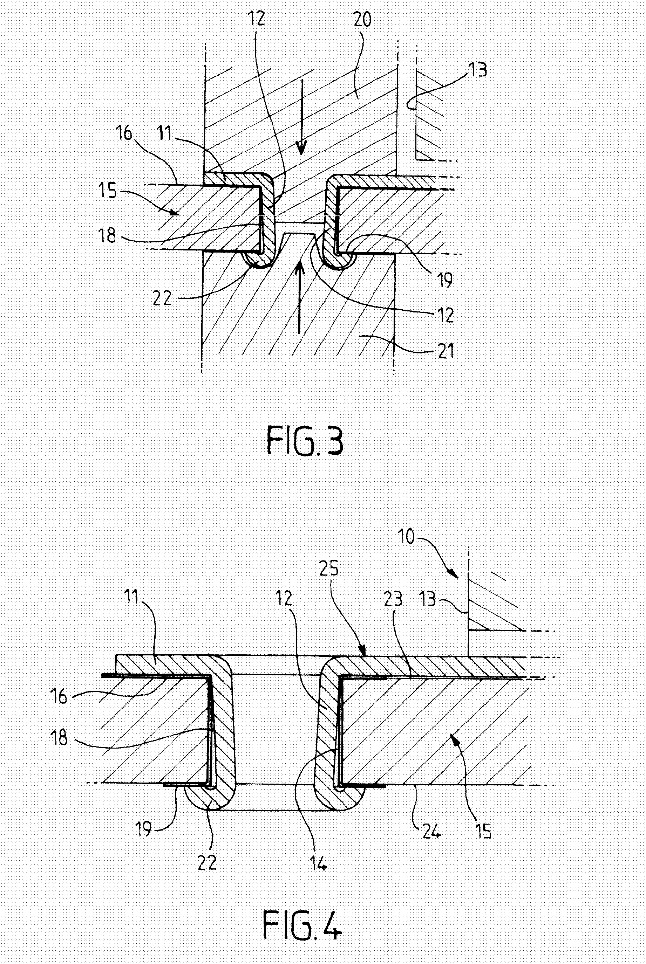

Les figures 1 et 2 représentent le composant 10 dans son état initial, c'est-à-dire quand l'élément en saillie 12 n'a pas encore été déformé. Pour relier mécaniquement et électriquement le composant 10 au support 15, il est prévu de déformer l'élément en saillie 12, comme le montre les figures 3 et 4.

La forme de l'élément en saille 12 est une forme qui admet une déformation de manière à créer une rivure 22 de dimensions supérieures au diamètre de l'orifice 14. Ainsi, il est possible de réaliser une fixation mécanique du type rivet ou sertissage : Sur la figure 4, la paroi plane 11 constitue une portion d'appui de la patte 25, qui est en appui contre la première face 23 du support 15, et l'élément en saillie 12 constitue une portion déformée comprenant une rivure 22 tournée vers et en appui contre la deuxième face 24 du support 15. Ce type de verrouillage positif présente une bonne résistance mécanique.

De plus, comme le montre la figure 4, la paroi plane 11 est serrée au contact de la zone métallique circulaire 16, et l'élément en saillie 12 est serré en contact avec la couche métallique 18 et la zone métallique circulaire 19. Autrement dit, la déformation de l'élément en saillie 12 permet également d'assurer la liaison électrique entre le corps 13 et la piste 17.

La déformation de l'élément en saillie 12 peut être obtenue à l'aide d'un outil comprenant un poinçon 20 et une matrice 21, comme le montre la figure 3. De préférence, L'outil comprend plusieurs poinçons et matrices actionnables simultanément, de manière à déformer les éléments en saille 12 de toutes les pattes 25 en même temps. Bien entendu, il est possible de déformer les éléments en saillie 12 d'une autre manière.

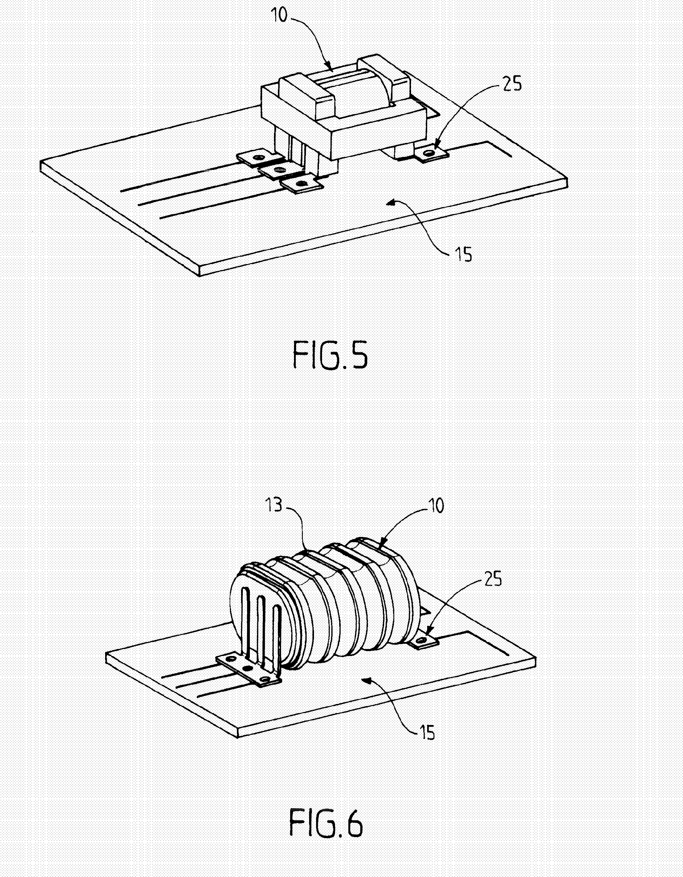

La figure 5 représente le composant 10 assemblé au support 15 de circuit imprimé, de manière à former un dispositif électrique ou électronique. La figure 6 représente une variante dans laquelle le corps 13 du composant 10 est constitué d'accumulateurs.

Bien que l'invention ait été décrite en liaison avec un mode de réalisation particulier, il est bien évident qu'elle n'y est nullement limitée et qu'elle comprend tous les équivalents techniques des moyens décrits ainsi que leurs combinaisons si celles-ci entrent dans le cadre de l'invention.

## Revendications

1. Composant (10) destiné à être monté sur un support (15) de circuit imprimé, comprenant un corps (13) et une patte (25) apte à être insérée dans et à traverser un orifice (14) ménagé dans le support de manière à fixer le corps au support et à relier électriquement le corps au support, **caractérisé par le fait que** la patte présente une portion d'appui (11) et une portion déformable (12), la portion déformable étant apte, quand la portion d'appui est en appui sur une première face (23) du support, à être déformée de manière à prendre appui sur une deuxième face (24) du support opposée à la première face, afin de fixer le corps au support et de relier électriquement le corps au support, sans soudure.

2. Composant selon la revendication 1, dans lequel la portion d'appui comprend une paroi plane (11), et la portion déformable comprend un élément faisant saillie (12) depuis la paroi plane.

3. Composant selon la revendication 2, dans lequel l'élément faisant saillie présente une forme cylindrique ou tronconique creuse.

4. Composant selon l'une des revendications 1 à 3, présentant un poids supérieur à 10 g.

5. Composant selon la revendication 4, dans lequel le corps comprend un transformateur et/ou un accumulateur et/ou un élément mécatronique.

6. Composant selon l'une des revendications 1 à 5, comprenant une pluralité de pattes (25) comprenant chacune une portion d'appui (11) et une portion déformable (12).

7. Dispositif électrique ou électronique, réalisé avec un composant (10) selon l'une des revendications 1 à 6, et comprenant un support (15) de circuit imprimé dans lequel est ménagé un orifice (14), la patte (25) du composant étant insérée dans l'orifice du support avec sa portion d'appui en appui sur une première face du support et sa portion déformable qui est déformée de manière à prendre appui sur une deuxième face du support opposée à la première face, afin de fixer le corps au support et de relier électriquement le corps au support, sans soudure.

8. Dispositif électrique ou électronique selon la revendication 7, dans lequel la portion déformée comprend une rivure (22) plus large que les dimensions de l'orifice et repliée vers la deuxième face du support.

9. Procédé de montage d'un dispositif électrique ou électronique selon la revendication 7 ou 8, comprenant les étapes consistant à :
- insérer la patte du composant dans l'orifice du support, avec sa portion d'appui en appui sur la première face du support et sa portion déformable qui fait saillie au niveau de la deuxième face du support
- déformer la portion déformable de manière à ce qu'elle prenne appui sur la deuxième face.

10. Procédé de montage selon la revendication 9, dans lequel l'étape de déformation est réalisée avec un outil comprenant un poinçon (20) et une matrice (21).
